# EUROPÄISCHE PATENTSCHRIFT

(11) **EP 4 224 202 B1**
(45) Veröffentlichungstag und Bekanntmachung des Hinweises auf die Patenterteilung: **30.07.2025**
(21) Anmeldenummer: 22155407.4
(22) Anmeldetag: 07.02.2022
(51) Int. Cl.: G01S 7/481, G01S 17/42, G01S 17/89

(54) **LASERSCANNER**
LASER SCANNER
BALAYEUR LASER

(43) Veröffentlichungstag der Anmeldung: 09.08.2023
(73) Patentinhaber: RIEGL Laser Measurement Systems GmbH, 3580 Horn (AT)
(72) Erfinder: ULLRICH, Andreas, 3003 Gablitz (AT); REICHERT, Rainer, 3580 Horn (AT)
(74) Vertreter: Weiser Voith Gugler Patentanwälte Partnerschaft

(56) Entgegenhaltungen:
- EP-A1- 3 447 521
- WO-A1-2019/064062

## Beschreibung

Die vorliegende Erfindung betrifft einen Laserscanner zum Scannen, insbesondere luftgestützten Scannen, einer Umgebung. Der Laserscanner umfasst einen Lasersender zum Aussenden eines Sendestrahls, einen Laserempfänger zum Empfangen des an der Umgebung reflektierten Sendestrahls als Empfangsstrahl, eine im Strahlengang der Sende- und Empfangsstrahlen angeordnete Strahlablenkeinrichtung in Form einer um eine Drehachse drehbaren Spiegelpyramide mit gegenüber der Drehachse geneigten Pyramidenseiten, welche jeweils eine Spiegelfacette bilden, und ein Gehäuse, in welchem der Lasersender, der Laserempfänger und die Strahlablenkeinrichtung angeordnet sind und das eine Grund- und eine Deckfläche, einen die Grund- und Deckfläche verbindenden Mantel, dessen lichte Weite geringer als die Gehäusehöhe zwischen Grund- und Deckfläche ist, und ein Fenster für die Sende- und Empfangsstrahlen aufweist, wobei die Strahlablenkeinrichtung dem Fenster benachbart und ihre Drehachse im Wesentlichen parallel zur Grundfläche ausgerichtet ist.

Ein solcher Laserscanner wird insbesondere zum mobilen Laserscannen eingesetzt und dazu an oder in ein Fahrzeug, insbesondere Luftfahrzeug, oder in eine dazu speziell vorgesehene, insbesondere bewegungsstabilisierende Plattform montiert, die wiederum am Fahrzeug befestigt ist. Beim Scannen wird der auf die sich drehende Strahlablenkeinrichtung gerichtete Sendestrahl von dieser periodisch über einen Scanwinkelbereich verschwenkt und dadurch zu einem Scanfächer aufgefächert, welcher die Umgebung zeilenweise in annähernd parallelen Scanzeilen abtastet. Derartige Laserscanner erlauben im Vergleich zu solchen, die den Sendestrahl z.B. mithilfe eines drehenden Risley-Prismas zu einem Scankegel brechen und die Umgebung damit beim mobilen Einsatz spiralförmig abtasten, eine gleichmäßigere Abtastung der Umgebung. Dieselbe den Sendestrahl jeweils ablenkende Spiegelfacette der Strahlablenkeinrichtung lenkt ebenso den an der Umgebung reflektierten, aus derselben Richtung eintreffenden Empfangsstrahl auf den Laserempfänger. Aus der Aussenderichtung des Sendestrahls und der Laufzeit bis zum Empfangen des Empfangsstrahls wird die Lage jedes abgetasteten Punktes der Umgebung gegenüber dem Laserscanner ermittelt und aus einer Vielzahl solcher Abtastpunkte z.B. ein 3D-Modell der Umgebung erstellt. Laserscanner dieser Art sind z.B. aus der EP 3 182 159 A1 oder der WO 2019/064062 A1 bekannt, wobei der Laserscanner der WO 2019/064062 A1 ferner einen Umlenkspiegel hat, welcher den Empfangsstrahl von der Strahlablenkeinrichtung auf den Laserempfänger umlenkt.

Das Gehäuse erleichtert die Montage in dafür vorgesehene Ladebuchten bzw. an Montagehalterungen verschiedener Fahrzeuge und die Demontage bei einem Fahrzeugwechsel. In der Außenwand des Fahrzeugs bzw. der Plattform ist eine Apertur, z.B. eine Außenwandluke od.dgl., für den Durchtritt der Sende- und Empfangsstrahlen vorgesehen. Einerseits soll die Apertur klein sein, um die Außenwandstruktur und die Luftströmung darüber möglichst wenig zu beeinträchtigen, andererseits besteht zuweilen der Bedarf, weitere Mess- und Aufzeichnungsgeräte, z.B. Kameras etc., zur gleichzeitigen Vermessung der Umgebung dieselbe Apertur nutzen zu lassen. Diese Messgeräte haben dann neben dem Laserscanner zusätzlichen Raumbedarf in der Ladebucht oder an der Montagehalterung, ohne dass die Apertur vergrößert werden soll.

Die Erfindung setzt sich zum Ziel, einen besonders kompakten Laserscanner zu schaffen, der eine besonders kleine Apertur und/oder die Anordnung zusätzlicher Messgeräte an derselben Apertur ermöglicht.

Dieses Ziel wird mit einem Laserscanner der einleitend genannten Art erreicht, bei welchem das Fenster in der Grundfläche liegt und der Laserempfänger näher zur Deck- als zur Grundfläche angeordnet ist, wobei im Gehäuse ein Umlenkspiegel der Grundfläche benachbart angeordnet ist, welcher den Empfangsstrahl von der Strahlablenkeinrichtung auf den Laserempfänger umlenkt, wobei zum Fokussieren des Empfangsstrahls auf den Laserempfänger im Strahlengang zwischen der Strahlablenkeinrichtung und dem Laserempfänger eine Empfangsoptik im Gehäuse angeordnet ist, welche Empfangsoptik eine optische Linse mit dezentraler optischer Achse ist, und wobei der Umlenkspiegel auch den Sendestrahl vom Lasersender auf die Strahlablenkeinrichtung umlenkt und dabei die optische Linse eine zur genannten optischen Achse parallele, davon beabstandete Ausnehmung für den Durchtritt des Sendestrahls hat.

Da der solcherart langgestreckte Laserscanner sein Fenster nicht im Gehäusemantel sondern in der Grundfläche hat, kann er hochkant hinter der Apertur montiert werden. Die Strahlablenkeinrichtung und der Umlenkspiegel erzielen gemeinsam eine kompakte Z-förmige Faltung des Strahlengangs. Die Faltung ermöglicht eine Optimierung des Verhältnisses zwischen der Grundfläche des Gehäuses zu der zum Empfangen des Empfangsstrahls wirksamen Fläche, d.h. der kleineren der beiden Flächen Spiegelfacettenfläche oder Fensterfläche im Strahlengang, und somit eine Maximierung der wirksamen Empfangsfläche bei gegebener Grundfläche, eine Minimierung der Grundfläche bei gegebener wirksamer Empfangsfläche oder eine Mischung daraus. Angesichts der zur Grundfläche im Wesentlichen parallelen Drehachse der Strahlablenkeinrichtung und dem näher der Deckfläche angeordneten Laserempfänger beträgt ein Umlenkwinkel des Umlenkspiegels etwa 90°, was eine besonders kleine Grundfläche des Gehäuses ermöglicht. Diese ist im Grunde lediglich von der Strahlablenkeinrichtung und dem Umlenkspiegel abhängig. So kann die Apertur in der Fahrzeugaußenwand klein gehalten werden und/oder verbleibt neben dem Laserscanner oder rund um diesen Freiraum zur Nutzung durch zusätzliche Mess- oder Aufzeichnungsgeräte, die dieselbe Umgebung synchron zum Laserscanner durch die Apertur hindurch vermessen.

"Im Wesentlichen parallel zur Grundfläche" bedeutet im Zusammenhang mit dem gegenständlichen Laserscanner, dass einerseits die Grundfläche nur abschnittsweise plan sein könnte, wobei die Drehachse lediglich zu einem der Abschnitte der Grundfläche parallel ist, und andererseits, dass die Drehachse optional eine geringfügige Neigung gegenüber der Grundfläche bzw. ihren Abschnitten in der Größenordnung einiger Winkelgrade aufweisen kann.

Die Empfangsoptik ermöglicht die Verwendung eines kleineren Lichtsensors für den Laserempfänger und begünstigt eine insgesamt kleinere Bauweise des Laserscanners.

Eine optische Linse baut dabei kompakt. Der Laserempfänger bzw. sein Lichtsensor ist infolge der dezentralen optischen Achse nicht zentral über der Empfangsoptik bzw. dem Umlenkspiegel anzuordnen, sondern in der optischen Achse, d.h. außermittig, insbesondere nahe der Mantelfläche des Gehäuses, sodass der verbleibende Raum im Gehäuseinneren besser nutzbar ist.

Infolge der zur optischen Achse parallelen Führung des Sendestrahls und der insgesamt Z-förmigen Faltung mithilfe des Umlenkspiegels sind Laserscanner, Laserempfänger und Strahlengang besonders kompakt zusammengefasst, was eine besonders kleine Bauweise des Laserscanners ermöglicht. Dies trifft umso mehr zu, wenn der Lasersender, wie bevorzugt, vom Umlenkspiegel gesehen hinter dem Laserempfänger an der Deckfläche angeordnet ist und dabei der Sendestrahl vom Lasersender mithilfe eines Lichtleiters am Laserempfänger vorbei zur Ausnehmung geleitet wird.

Besonders günstig ist dabei, wenn der Sendestrahl parallel zur Drehachse auf die Strahlablenkeinrichtung trifft. Dadurch ergeben sich weitgehend geradlinige parallele Scanzeilen.

Bevorzugt ist die Empfangsoptik zwischen Umlenkspiegel und Laserempfänger angeordnet. Da infolgedessen der Raum zwischen dem Umlenkspiegel und der Strahlablenkeinrichtung frei bleibt, können diese beiden näher aneinander angeordnet und kann die Grundfläche des Gehäuses in weiterer Folge verkleinert werden.

In einer vorteilhaften Variante des Laserscanners hat das Fenster in Richtung der Drehachse gesehen den Querschnitt eines Kreis- oder Ellipsenbogens oder eines offenen Polygonzugs, in dessen Innerem die Drehachse liegt. Somit hat das Fenster eine konkave Seite, an welcher die Strahlablenkeinrichtung angeordnet ist. Die Spiegelpyramide kann in dieser Variante zumindest teilweise zwischen seitliche Schenkel des Polygonzugs bzw. die Enden des Kreis- bzw. Ellipsenbogens ragen. Dies führt selbst bei schmaler Bauweise des Laserscanners zu einer gegenüber einem planen Fenster besseren Ausnutzung der jeweils aktiven Spiegelfacette, d.h. jener Spiegelfacette, die momentan im Strahlengang der Sende- und Empfangsstrahlen liegt, indem die gesamte Fläche dieser Spiegelfacette für den Empfangsstrahl nutzbar gemacht werden kann.

Günstig ist ferner, wenn die Spiegelfacetten voneinander jeweils verschiedene Neigung gegenüber der Drehachse haben. Das Scannen der Umgebung erfolgt dadurch in mehreren zueinander annähernd parallelen Scanzeilen.

Um allfällige Wärme aus dem Gehäuse besser abzuleiten, ohne die Grundfläche des Gehäuses zu vergrößern, hat bevorzugt das Gehäuse an der Außenseite seiner Deckfläche einen Kühlkörper. Dadurch wird z.B. Stauwärme im Kopfbereich des Gehäuses über die Deckfläche zuverlässig abgeführt. Die Möglichkeit, weitere Sensoren unmittelbar an das Gehäuse anzulagern, wird nicht durch übermäßige Abwärme aus dem Gehäuse eingeschränkt. Ferner kann, wenn der Lasersender an der Deckfläche angeordnet ist, dessen Abwärme unmittelbar abgeführt werden.

Die Erfindung wird nachstehend anhand eines in den beigeschlossenen Zeichnungen dargestellten Ausführungsbeispiels näher erläutert. In den Zeichnungen zeigen:
Fig. 1 eine Ausführungsform eines erfindungsgemäßen Laserscanners in einem Längsschnitt in der Ebene seines Sendestrahls; und
Fig. 2 einen Ausschnitt des Laserscanners von Fig. 1 entlang einer Schnittlinie A - A.

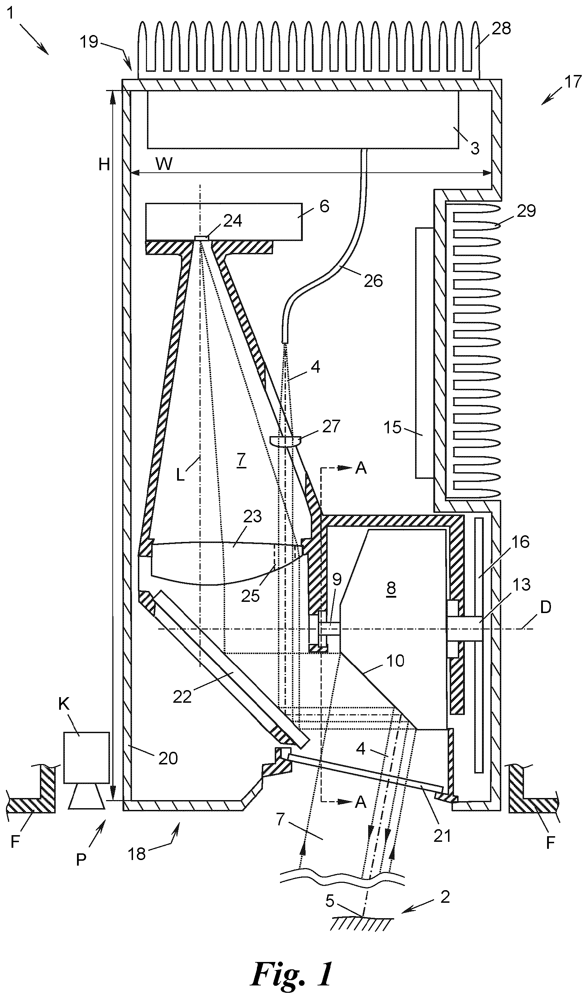

Fig. 1 zeigt einen Laserscanner 1 zum Scannen einer Umgebung 2. Der Laserscanner 1 kann dabei entweder zum stationären Scannen an einem Gerüst od.dgl. oder zum mobilen Scannen an einem Fahrzeug F, insbesondere zum luftgestützten Scannen an einem Luftfahrzeug, montiert sein, z.B. in oder hinter einer dafür vorgesehene Apertur P, z.B. einer Außenwandluke od.dgl. Dieselbe Apertur P können, falls gewünscht, weitere Mess- und Aufzeichnungsgeräte, z.B. eine Kamera K etc., zur gleichzeitigen Vermessung der Umgebung nutzen.

Der Laserscanner 1 umfasst einen Lasersender 3, welcher einen gepulsten oder modulierten Sendestrahl 4 aussendet, der jeweils in einem Auftreffpunkt 5 auf die Umgebung 2 trifft und dort zumindest teilweise reflektiert wird, und einen Laserempfänger 6, welcher den an der Umgebung 2 reflektierten Sendestrahl 4 als Empfangsstrahl 7 empfängt. Im Strahlengang der Sende- und Empfangsstrahlen 4, 7 ist eine Strahlablenkeinrichtung 8 des Laserscanners 1 angeordnet. Die Strahlablenkeinrichtung 8 ist eine Spiegelpyramide, die an einer Welle 9 um eine Drehachse D drehbar gelagert ist und gegenüber der Drehachse D geneigte Pyramidenseiten hat, welche jeweils eine Spiegelfacette 10 - 12 bilden. Im dargestellten Beispiel hat die Spiegelpyramide drei Spiegelfacetten 10 - 12 bzw. Pyramidenseiten, alternativ kann sie vier oder mehr Pyramidenseiten haben. Entweder haben alle Spiegelfacetten dieselbe Neigung gegenüber der Drehachse D oder zumindest zwei - oder überhaupt alle - voneinander jeweils verschiedene Neigung gegenüber der Drehachse D.

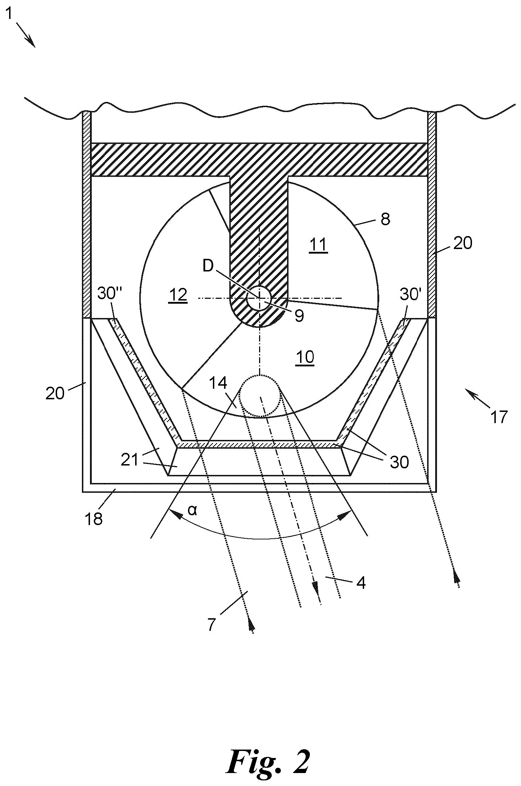

Es versteht sich, dass die Spiegelpyramide beliebige Pyramidenform mit beliebiger polygonzugförmiger Basis haben kann, u.zw. sowohl gerade als auch "schief", wobei die Pyramidenachse nicht senkrecht auf die Basis steht, regelmäßig oder unregelmäßig, spitz oder "stumpf" ("Pyramidenstumpf"), und an der Spitze und/oder Basis beschnitten sein kann, wie die in den Fig. 1 und 2 gezeigte Pyramide, deren Basis kreisförmig beschnitten ist, um bei ihrer Drehung den Luftwiderstand zu verringern.

Die Welle 9 der Spiegelpyramide wird von einem Motor 13 angetrieben, sodass der Sendestrahl 4 jeweils auf eine aktive Spiegelfacette 10 - 12 trifft, d.h. jene Spiegelfacette 10 - 12, die momentan im Strahlengang der Sende- und Empfangsstrahlen 4, 7 liegt. Im dargestellten Beispiel trifft der Sendestrahl 4 unmittelbar neben dem äußeren Rand der Spiegelpyramide auf die jeweils aktive Spiegelfacette 10 - 12. Der Empfangsstrahl 7 trifft auf die gesamte aktive Spiegelfacette 10 - 12, u.zw. genau aus jener Richtung, in welche der Sendestrahl 4 ausgesendet wurde. Infolge der Drehbewegung der Spiegelpyramide wird der Sendestrahl 4 periodisch über einen Scanwinkel α verschwenkt, um einen Scanfächer 14 zu bilden (Fig. 2). Mit dem Scanfächer 14 wird die Umgebung 2 zeilenweise, insbesondere Punkt für Punkt in Zeilen abgetastet.

Eine Elektronikeinheit 15 steuert den Laserscanner 3 und wertet Empfangssignale des Laserempfängers 6 aus, um daraus eine Laufzeit der Sende- und Empfangsstrahlen 4, 7 zu ermitteln. Die Elektronikeinheit 15 steuert ferner - optional mithilfe einer Motorsteuerung 16 - die Drehbewegung des Motors 13 bzw. der Strahlablenkeinrichtung 8. Aus der ermittelten Laufzeit kann die Elektronikeinheit 15 die Entfernung des Laserscanners 1 vom Auftreffpunkt 5 des Sendestrahls 4 auf der Umgebung 2 und aus der Stellung der aktiven Spiegelfacette 10 - 12 beim Aussenden des Sendestrahls 4 die Richtung des Auftreffpunkts 5 aus Sicht des Laserscanners 1 ermitteln, wie im Stand der Technik bekannt ist. Daraus kann entweder die Elektronikeinheit 15 oder eine vom Laserscanner 1 separate Recheneinheit die Lage des Auftreffpunkts 5 gegenüber dem Laserscanner 1 errechnen und optional aus einer Vielzahl von Auftreffpunkten in bekannter Weise eine 3D-Punktwolke bzw. ein 3D-Modell der Umgebung 2 erzeugen.

Der Laserscanner 1 umfasst ferner ein Gehäuse 17, in welchem der Lasersender 3, der Laserempfänger 6, die Strahlablenkeinrichtung 8 sowie weitere Komponenten, z.B. die Elektronikeinheit 15, der Motor 13, seine optionale Motorsteuerung 16 etc., angeordnet sind. Das Gehäuse 17 ist z.B. etwa zylinder- oder prismenförmig mit einer Grund- und einer Deckfläche 18, 19 und einem diese verbindenden Mantel 20 und ist langgestreckt, sodass der Mantel 20 eine geringere lichte Weite W hat, als die Gehäusehöhe H zwischen Grund- und Deckfläche 18, 19 beträgt. Das langgestreckte Gehäuse 17 ist nicht zwingend völlig regelmäßig geformt, sondern kann z.B. Vertiefungen, Vorsprünge etc. und zusätzlich Öffnungen - z.B. zur Lüftung - haben.

In seiner Grundfläche 18 hat das Gehäuse 17 ein Fenster 21 für die Sende- und Empfangsstrahlen 4, 7. Dem Fenster 21 benachbart ist im Gehäuse 17 die Strahlablenkeinrichtung 8 angeordnet, u.zw. derart, dass ihre Drehachse D zur Grundfläche 18 im Wesentlichen parallel ausgerichtet ist, d.h. dass einerseits die Grundfläche 18 auch nur abschnittsweise plan und die Drehachse D zu einem der Abschnitte parallel sein könnte, und dass andererseits die Drehachse D optional eine geringfügige Neigung gegenüber der Grundfläche 18 bzw. ihren Abschnitten in der Größenordnung einiger Winkelgrade aufweisen kann.

Der Grundfläche 18 benachbart ist im Gehäuse 6 ferner ein Umlenkspiegel 22 angeordnet. Der Umlenkspiegel 22 lenkt den von der Strahlablenkeinrichtung 8 kommenden Empfangsstrahl 7 auf den näher zur Deckfläche 19 als zur Grundfläche 18 im Gehäuse 17 angeordneten Laserempfänger 6, d.h. in Richtung der Deckfläche 19, um, u.zw. in der dargestellten Ausführungsform um einen Winkel von etwa 90°, in anderen Ausführungsformen um einen Winkel zwischen 70° und 110°. Das Zusammenwirken des Umlenkspiegels 22 mit der Strahlablenkeinrichtung 8 bewirkt eine Z-förmige Faltung des Empfangsstrahls 7 im Inneren des Gehäuses 17, wodurch eine schmale Gehäuseform begünstigt wird.

Der Laserempfänger 6 könnte grundsätzlich von jeder in der Technik bekannten Art sein, beispielsweise ein großformatiger fotoempfindlicher Sensor, ein CCD-Chip usw. Zum Fokussieren des Empfangsstrahls 7 auf den Laserempfänger 6 ist im Strahlengang zwischen der Strahlablenkeinrichtung 8 und dem Laserempfänger 6 eine Empfangsoptik 23 im Gehäuse 17 angeordnet, u.zw. entweder zwischen Strahlablenkeinrichtung 8 und Umlenkspiegel 22 oder - wie im Beispiel der Fig. 1 - zwischen Umlenkspiegel 22 und Laserempfänger 6. Dazu hat der Laserempfänger 6 einen im Fokus der Empfangsoptik 23 angeordneten Lichtsensor 24, z.B. einen Photomultiplier oder einen Lawinenfotodiode. Die Empfangsoptik 23 ist eine optische Linse. Diese hat eine dezentrale optische Achse L, sodass der Empfangsstrahl 7 auch dezentral fokussiert wird und der Laserempfänger 6 bzw. sein Lichtsensor 24 dezentral im Gehäuse 17 über dem Umlenkspiegel 22 angeordnet ist.

Gemäß Fig. 1 trifft der Sendestrahl 4 parallel zur Drehachse D auf die Strahlablenkeinrichtung 8, d.h. die hier aktive Spiegelfacette 10. Dies führt zu einer weitgehend geraden Scanzeile. Alternativ kann der Sendestrahl 4 gegenüber der Drehachse D zumindest geringfügig geneigt sein.

Der Umlenkspiegel 22 lenkt nicht nur den Empfangsstrahl 7 von der Strahlablenkeinrichtung 8 auf den Laserempfänger 6, sondern auch den Sendestrahl 4 vom Lasersender 3 auf die Strahlablenkeinrichtung 8 um. Die optische Linse hat dabei eine zu ihrer optischen Achse L parallele, von der optischen Achse L beabstandete Ausnehmung (hier: eine Bohrung) 25 für den ungebrochenen, zur optischen Achse L parallelen Durchtritt des Sendestrahls 4, u.zw. unabhängig davon, ob die Empfangsoptik 23 dem Umlenkspiegel vor- oder nachgeordnet ist.

Im Beispiel der Fig. 1 ist der Lasersender 3 vom Umlenkspiegel 22 gesehen hinter dem Laserempfänger 6 angeordnet, u.zw. hier unmittelbar an der Deckfläche 19 des Gehäuses 17. Der Sendestrahl 4 wird dabei vom Lasersender 3 mithilfe eines Lichtleiters 26 am Laserempfänger 6 vorbei zur Ausnehmung 25 geleitet. Optional ist ausgangsseitig des Lichtleiters eine Kollimatorlinse 27 angeordnet. Anstelle des Lichtleiters 26 könnte der Sendestrahl 4 mithilfe z.B. eines oder mehrerer Spiegel am Laserempfänger 6 vorbei zur Ausnehmung 25 geleitet werden und/oder der Lasersender 3 anderswo im Gehäuse 17 angeordnet sein, sogar im Empfangsstrahl 7, z.B. wenn der Lasersender 3 ein sehr kleiner Halbleiterlaser ist.

Optional hat das Gehäuse 17 an der Außenseite seiner Deckfläche 19 einen Kühlkörper 28. Im Beispiel der Fig. 1 trägt das Gehäuse 17 an der Außenseite des Mantels 20 ferner einen optionalen weiteren Kühlkörper 29 für die Elektronikeinheit 15.

Wie in Fig. 2 gezeigt, kann das Fenster 21 nicht nur plan sein, sondern alternativ in Richtung der Drehachse D gesehen den Querschnitt eines Kreis- oder Ellipsenbogens oder (im dargestellten Fall) eines offenen Polygonzugs 30 haben. Die Drehachse D liegt dabei im Inneren des Polygonzugs 30, d.h. an seiner konkaven Seite, wobei zumindest ein Teil der Spiegelpyramide zwischen die äußeren Schenkel 30', 30" des Polygonzugs 30 bzw. zwischen die Enden des Kreis- oder Ellipsenbogens ragt.

Die Erfindung ist nicht auf die dargestellten Ausführungsformen beschränkt, sondern umfasst alle Varianten, Modifikationen und deren Kombinationen, die in den Rahmen der angeschlossen Ansprüche fallen.

## Patentansprüche

1. Laserscanner zum Scannen, insbesondere luftgestützten Scannen, einer Umgebung (2), umfassend
einen Lasersender (3) zum Aussenden eines Sendestrahls (4),
einen Laserempfänger (6) zum Empfangen des an der Umgebung (2) reflektierten Sendestrahls (4) als Empfangsstrahl (7),
eine im Strahlengang der Sende- und Empfangsstrahlen (4, 7) angeordnete Strahlablenkeinrichtung (8) in Form einer um eine Drehachse (D) drehbaren Spiegelpyramide mit gegenüber der Drehachse (D) geneigten Pyramidenseiten, welche jeweils eine Spiegelfacette (10, 11, 12) bilden, und
ein Gehäuse (17), in welchem der Lasersender (3), der Laserempfänger (6) und die Strahlablenkeinrichtung (8) angeordnet sind und das eine Grund- und eine Deckfläche (18, 19), einen die Grund- und Deckfläche (18, 19) verbindenden Mantel (20), dessen lichte Weite (W) geringer als die Gehäusehöhe (H) zwischen Grund- und Deckfläche (18, 19) ist, und ein Fenster (21) für die Sende- und Empfangsstrahlen (4, 7) aufweist, wobei die Strahlablenkeinrichtung (8) dem Fenster (21) benachbart und ihre Drehachse (D) im Wesentlichen parallel zur Grundfläche (18) ausgerichtet ist, und wobei im Gehäuse (17) ein Umlenkspiegel (22) angeordnet ist, welcher den Empfangsstrahl (7) von der Strahlablenkeinrichtung (8) auf den Laserempfänger (6) umlenkt,
**dadurch gekennzeichnet, dass**
das Fenster (21) in der Grundfläche (18) liegt, der Laserempfänger (6) näher zur Deck- als zur Grundfläche (19, 18) und der Umlenkspiegel (22) der Grundfläche (18) benachbart im Gehäuse (17) angeordnet ist, wobei zum Fokussieren des Empfangsstrahls (7) auf den Laserempfänger (6) im Strahlengang zwischen der Strahlablenkeinrichtung (8) und dem Laserempfänger (6) eine Empfangsoptik (23) im Gehäuse (17) angeordnet ist, welche Empfangsoptik (23) eine optische Linse mit dezentraler optischer Achse (L) ist, und wobei der Umlenkspiegel (22) ferner den Sendestrahl (4) vom Lasersender (3) auf die Strahlablenkeinrichtung (8) umlenkt und dabei die optische Linse eine zur genannten optischen Achse (L) parallele, von der genannten optischen Achse (L) beabstandete Ausnehmung (25) für den Durchtritt des Sendestrahls (4) hat.

2. Laserscanner nach Anspruch 1, **dadurch gekennzeichnet, dass** der Sendestrahl (4) parallel zur Drehachse (D) auf die Strahlablenkeinrichtung (8) trifft.

3. Laserscanner nach Anspruch 1 oder 2, **dadurch gekennzeichnet, dass** die Empfangsoptik (23) zwischen Umlenkspiegel (22) und Laserempfänger (6) angeordnet ist.

4. Laserscanner nach einem der Ansprüche 1 bis 3, **dadurch gekennzeichnet, dass** der Lasersender (3) vom Umlenkspiegel (22) gesehen hinter dem Laserempfänger (6) an der Deckfläche (19) angeordnet ist, wobei der Sendestrahl (4) vom Lasersender (3) mithilfe eines Lichtleiters (26) am Laserempfänger (6) vorbei zur Ausnehmung (25) geleitet wird.

5. Laserscanner nach einem der Ansprüche 1 bis 4, **dadurch gekennzeichnet, dass** das Fenster (21) in Richtung der Drehachse (D) gesehen den Querschnitt eines Kreis- oder Ellipsenbogens oder eines offenen Polygonzugs (30) hat, in dessen Innerem die Drehachse (D) liegt.

6. Laserscanner nach einem der Ansprüche 1 bis 5, **dadurch gekennzeichnet, dass** die Spiegelfacetten (10, 11, 12) voneinander jeweils verschiedene Neigung gegenüber der Drehachse (D) haben.

7. Laserscanner nach einem der Ansprüche 1 bis 6, **dadurch gekennzeichnet, dass** das Gehäuse (17) an der Außenseite seiner Deckfläche (19) einen Kühlkörper (28) hat.

## Claims

1. Laser scanner for scanning, in particular airborne scanning, of an environment (2), comprising
a laser transmitter (3) for transmitting a transmission beam (4),
a laser receiver (6) for receiving the transmission beam (4) reflected on the environment (2) as a receive beam (7),
a beam-deflection device (8) arranged in the beam path of the transmission and receive beams (4, 7) in the form of a mirror pyramid that is rotatable about a rotational axis (D) and has pyramid sides inclined relative to the rotational axis (D) that each form a mirror facet (10, 11, 12), and
a housing (17), in which the laser transmitter (3), the laser receiver (6), and the beam-deflection device (8) are arranged and which comprises a bottom face and a top face (18, 19), a lateral shell (20) which connects the bottom face and top face (18, 19) and has an inner width (W) that is less than the housing height (H) between the bottom face and top face (18, 19), and a window (21) for the transmission and receive beams (4, 7), wherein the beam-deflection device (8) is adjacent to the window (21) and its rotational axis (D) is oriented substantially in parallel with the bottom face (18), and wherein a deflecting mirror (22) is arranged in the housing (17) deflecting the receive beam (7) from the beam-deflection device (8) onto the laser receiver (6),
**characterized in that**
the window (21) is in the bottom face (18), the laser receiver (6) is arranged closer to the top face than to the bottom face (19, 18) and the deflecting mirror (22) is arranged adjacent to the bottom face (18) in the housing (17), wherein, for focussing the receive beam (7) on the laser receiver (6), an optical receiving system (23) is arranged in the housing (17) in the beam path between the beam-deflection device (8) and the laser receiver (6), which optical receiving system (23) is an optical lens having a decentralized optical axis (L), and wherein the deflecting mirror (22) further deflects the transmission beam (4) from the laser transmitter (3) onto the beam-deflection device (8), the optical lens having a cut-out (25), which is in parallel with said optical axis (L) and spaced apart from said optical axis (L), for the transmission beam (4) to pass through.

2. Laser scanner according to claim 1, **characterized in that** the transmission beam (4) impinges on the beam-deflection device (8) in parallel with the rotational axis (D).

3. Laser scanner according to claim 1 or 2, **characterized in that** the optical receiving system (23) is arranged between the deflecting mirror (22) and the laser receiver (6).

4. Laser scanner according to any one of claims 1 to 3, **characterized in that**, when viewed from the deflecting mirror (22), the laser transmitter (3) is arranged behind the laser receiver (6) on the top face (19), wherein the transmission beam (4) is guided from the laser transmitter (3), past the laser receiver (6) and to the cut-out (25) by means of an optical waveguide (26).

5. Laser scanner according to any one of claims 1 to 4, **characterized in that**, when viewed in the direction of the rotational axis (D), the window (21) has the cross section of an arc of a circle or an arc of an ellipse, or of an open polygon (30), in the interior of which the rotational axis (D) is positioned.

6. Laser scanner according to any one of claims 1 to 5, **characterized in that** the mirror facets (10, 11, 12) each have inclinations relative to the rotational axis (D) that are different from one another.

7. Laser scanner according to any one of claims 1 to 6, **characterized in that** the housing (17) has a cooling body (28) on the outside of its top face (19).

## Revendications

1. Scanner laser pour le balayage, notamment le balayage aérien, d'un environnement (2), comprenant
un émetteur laser (3) pour l'émission d'un faisceau d'émission (4),
un récepteur laser (6) pour la réception du faisceau d'émission (4) réfléchi sur l'environnement (2) en tant que faisceau de réception (7),
un dispositif de déviation de faisceau (8) disposé dans le trajet de faisceau des faisceaux d'émission et de réception (4, 7) sous la forme d'une pyramide à miroirs rotative autour d'un axe de rotation (D) avec des faces de pyramide inclinées par rapport à l'axe de rotation (D), lesquelles forment respectivement une facette du miroir (10, 11, 12), et
un boitier (17) dans lequel sont disposés l'émetteur laser (3), le récepteur laser (6) et le dispositif de déviation de faisceau (8) et qui présente une surface de base et une surface de couverture (18, 19), une enveloppe (20) reliant les surfaces de base et de couverture (18, 19), dont la largeur intérieure (W) est inférieure à la hauteur de boitier (H) entre les surfaces de base et de couverture (18, 19), et une fenêtre (21) pour les faisceaux d'émission et de réception (4, 7), dans lequel le dispositif de déviation de faisceau (8) est adjacent à la fenêtre (21) et son axe de rotation (D) est orienté essentiellement parallèlement par rapport à la surface de base (18), et dans lequel un miroir de déviation (22) est disposé dans le boitier (17), lequel dévie le faisceau d'émission (7) provenant du dispositif de déviation de faisceau (8) sur le récepteur laser (6),
**caractérisé en ce que**
la fenêtre (21) se situe dans la surface de base (18), le récepteur laser (6) est disposé plus près de la surface de couverture que de la surface de base (19, 18) et le miroir de déviation (22) est disposé dans le boitier (17) adjacent à la surface de base (18), dans lequel, pour la focalisation du faisceau de réception (7) sur le récepteur laser (6), un système optique de réception (23) est disposé dans le boitier (17) dans le trajet de faisceau entre le dispositif de déviation de faisceau (8) et le récepteur laser (6), lequel système optique de réception (23) est une lentille optique avec un axe optique (L) décentré, et dans lequel le miroir de déviation (22) dévie en outre le faisceau d'émission (4) de l'émetteur laser (3) sur le dispositif de déviation de faisceau (8), la lentille optique ayant un évidement (25), qui est parallèle audit axe optique (L) et espacé dudit axe optique (L), pour le passage du faisceau d'émission (4).

2. Scanner laser selon la revendication 1, **caractérisé en ce que** le faisceau d'émission (4) atteint le dispositif de déviation de faisceau (8) parallèlement à l'axe de rotation (D).

3. Scanner laser selon la revendication 1 ou 2, **caractérisé en ce que** le système optique de réception (23) est disposé entre le miroir de déviation (22) et le récepteur laser (6).

4. Scanner laser selon l'une des revendications 1 à 3, **caractérisé en ce que** l'émetteur laser (3), vu à partir du miroir de déviation (22), est disposé derrière le récepteur laser (6) sur la surface de couverture (19), dans lequel le faisceau d'émission (4) est guidé de l'émetteur laser (3) au moyen d'un guide de lumière (26) en contournant le récepteur laser (6) vers l'évidement (25).

5. Scanner laser selon l'une des revendications 1 à 4, **caractérisé en ce que** la fenêtre (21), vue dans la direction de l'axe de rotation (D), a pour section transversale un arc circulaire ou un arc elliptique ou un polygone ouvert (30) à l'intérieur duquel se situe l'axe de rotation (D).

6. Scanner laser selon l'une des revendications 1 à 5, **caractérisé en ce que** les facettes de miroir (10, 11, 12) ont respectivement les unes par rapport aux autres une inclinaison différente par rapport à l'axe de rotation (D).

7. Scanner laser selon l'une des revendications 1 à 6, **caractérisé en ce que** le boitier (17) possède un dissipateur thermique (28) sur la face extérieure de sa surface de couverture (19).
